Europäisches Patentamt

European Patent Office

Office européen des brevets

(19)

(11) Numéro de publication: **0 014 604**
**B1**

(12) **FASCICULE DE BREVET EUROPEEN**

(45) Date de publication du fascicule du brevet: **09.02.83**

(21) Numéro de dépôt: **80400036.2**

(22) Date de dépôt: **11.01.80**

(51) Int. Cl.³: **H 03 H 19/00,
H 03 H 15/02**

(54) Filtre à échantillonnage.

(30) Priorité: **02.02.79 FR 7902765**

(43) Date de publication de la demande:
**20.08.80 Bulletin 80/17**

(45) Mention de la délivrance du brevet:
**09.02.83 Bulletin 83/6**

(84) Etats contractants désignés:
**DE GB NL**

(56) Documents cités:
**FR - A - 2 422 292**

**PROCEEDINGS OF THE INSTITUTION OF
ELECTRICAL ENGINEERS, vol. 125, no. 6, juin
1978, Londres, GB A. R. OWENS et al.
"Interpolation of sampled-data filter output",
pages 489—494.**

(73) Titulaire: **THOMSON-CSF
173, Boulevard Haussmann
F-75379 Paris Cedex 08 (FR)**

(72) Inventeur: **Picquendar, Jean-Edgar
"THOMSON-CSF" - SCPI 173, bld Haussmann
F-75360 Paris Cedex 08 (FR)**

(74) Mandataire: **Desperrier, Jean-Louis et al,
THOMSON-CSF SCPI 173, Bld Haussmann
F-75379 Paris Cedex 08 (FR)**

Courier Press, Leamington Spa, England.

## Filtre à échantillonnage

La présente invention se rapporte aux filtres à échantillonnage. Ces filtres sont analogues aux filtres numériques parce qu'ils mettent en oeuvre un procédé d'échantillonnage, mais ils en diffèrent parce que les échantillons utilisés ne sont pas numérisés. Cette analogie permet d'utiliser les méthodes de synthèse utilisées dans le calcul des filtres numériques. De tels filtres sont particulièrement utiles dans les autocommutateurs téléphoniques du type temporel.

Il est connu de fabriquer de tels filtres et on en trouvera une description dans l'article "Transversal filtering Using Charge-Transfer Devices" publié par Dennis D. BUSS et al, dans la volume SC8, No 2, d'avril 1973 de la revue "IEEE Journal of Solid-State Circuits".

Les dispositifs à transfert de charges utilisés dans ces filtres sont également connus. Nous les nommerons suivant la notation française DTC (CCD dans les documents en langue anglo-saxonne). On en trouvera une description détaillée dans l'article "Charge-Coupled Devices" publié par Gilbert F. AMELIO dans le volume 230, No 2 Février 1974 de la revue "Scientific American".

L'échantillonnage utilisé perturbe la courbe de réponse du filtre et provoque des phénomènes connus par exemple sous le nom de "repliement de spectre" ou de "fantomes". Afin de minimiser ces phénomènes, la sortie du filtre se fait le plus souvent sur un circuit de type "échantillonnage et maintien" qui permet d'obtenir un signal de sortie en marches d'escalier dont le spectre est moins étendu que celui d'un signal composé d'impulsions étroites distinctes.

Il est néanmoins souvent nécessaire de compléter l'action d'un tel filtre par un filtrage analogique plus ou moins sommaire selon les résultats désirés C'est notamment le cas en téléphonie où l'on utilise des filtres complémentaires dits "anti-lobes" car on a besoin d'avoir une atténuation très importante des signaux parasites hors-bande.

On sait pour réduire au minimum le filtrage analogique utiliser un dispositif que nous appellerons "interpolateur d'ordre 1" et qui est parfois connu sous le nom de "circuit échantillonnage et maintien d'ordre 1" par opposition au circuit de sortie vu plus haut, lequel est dans ce cas nommé "circuit échantillonnage et maintien d'ordre 0".

Cette méthode d'interpolation linéaire entre deux sommes pondérées successives est connue de l'article intitulé "Interpolation of sampled-data filter output" publié par A. R. Owens et al dans "Proceedings of the Institution of Electrical Engineers", vol. 125 juin 1978.

Le but de l'invention est de remplacer les circuits de soustraction de Owens par un DTC comprenant une cellule de plus et utilisant un autre ensemble de coefficients de pondération.

D'autres particularités et avantages de l'invention apparaîtront clairement dans la description suivante présentée à titre d'exemple non limitatif et faite en regard des figures annexées qui représentent:

la figure 1, un filtre de type connu utilisant un dispositif à transfert de charge et un interpolateur d'ordre 1;

la figure 2, un diagramme des temps des signaux présents en différents points du filtre.

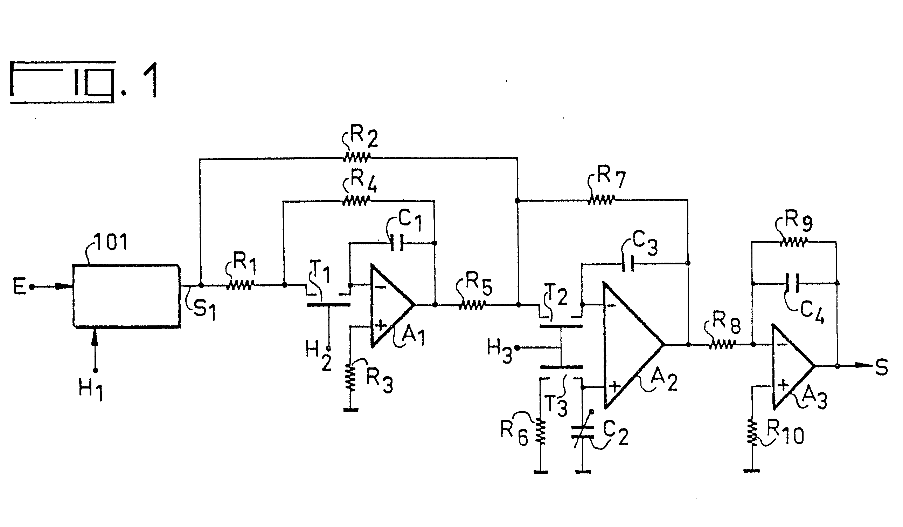

Le filtre représenté en figure 1 n'est décrit que pour expliquer le fonctionnement du filtre selon l'invention et comprend un dispositif à transfert de charge pondéré de manière connue pour réaliser une fonction de filtrage déterminée, et muni de dispositifs annexes tels qu'un générateur de signaux de transfert et un circuit échantillonnage et maintien d'ordre 0. Ce DTC et ses circuits annexes sont contenus dans un boîtier 101 qui reçoit le signal à filtrer E et un signal d'horloge $H_1$. Le signal ainsi filtré et contenant de signaux parasites sort sur une sortie $S_1$ et est appliqué par l'intermédiaire d'une résistance $R_1$ sur un premier transistor interrupteur $T_1$, du type à effet de champ dans cet exemple de réalisation, et par l'intermédiaire d'une résistance $R_2$ sur un deuxième transistor interrupteur $T_2$.

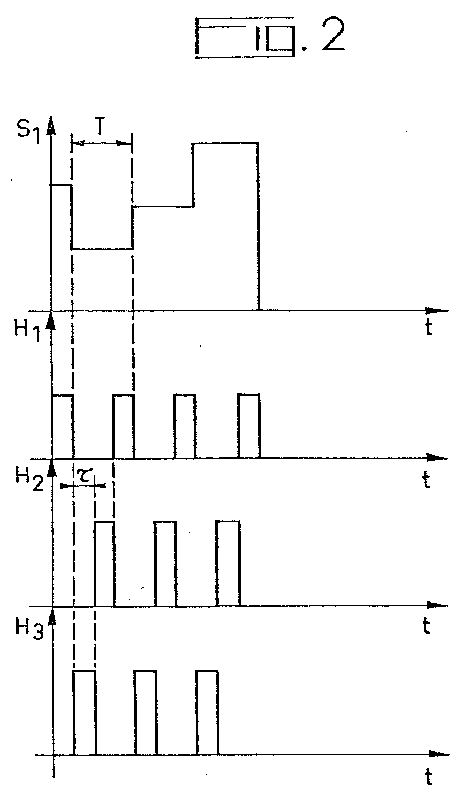

Ce signal $S_1$ est représenté en figure 2 en compagnie des divers signaux d'horloge utilisés dans le filtre. Il est composé de marches dont le début est en phase avec le front arrière des impulsions du signal d'horloge $H_1$. Cette forme en marches est caractéristique du circuit échantillonnage et maintien d'ordre 0 de sortie du boitier 101.

Sur l'électrode de commande de $T_1$, on applique un signal d'horloge $H_2$ semblable à $H_1$ et représenté en figure 2 mais dont le front avant des impulsions est décalé d'une durée $\tau$ par rapport au front arrière des impulsions de $H_1$; le front arrière des impulsions de $H_2$ coincidant dans cet exemple avec le front avant des impulsions de $H_1$ et ne devant pas de toute façon déborder sur les transitions entre les marches. De cette manière $T_1$ est momentanément fermé pendant de courts instants par ces impulsions, ce qui permet de transmettre le signal $S_1$ sur l'entrée — d'un premier amplificateur différentiel $A_1$ dont l'entrée + est reliée à la masse par une résistance $R_3$. Cet amplificateur est monté en contre-réaction par une résistance $R_4$ entre sa sortie et l'entrée de $T_1$ et par un condensateur $C_1$ entre cette sortie et son entrée —. En prenant par exemple pour $C_1$ une valeur de 220 pF et pour $R_4$ et $R_1$ une valeur commune de 4kΩ, on met ainsi en mémoire le signal $-S_1$ dans ce condensateur avec un retard égal à $\tau$. En effet $C_1$ se charge quand $T_1$ est fermé et reste chargé quand $T_1$ est ouvert.

Le signal en sortie de $A_1$, représentant donc $-S_1$ avec un retard $\tau$, est appliqué par une résist-

ance $R_5$ sur $T_2$ en parallèle avec $S_1$ qui arrive par $R_2$. $T_2$ reçoit sur son électrode de commande un signal d'horloge $H_3$ représenté en figure 2, semblable à $H_1$ et $H_2$, mais dont les impulsions sont insérées entre celles de $H_1$ et de $H_2$ sans déborder ni sur les unes, ni sur les autres. Par commodité on a représenté sur la figure les situations extrêmes où les fronts de $H_1$, $H_2$ et $H_3$ coincident, mais ils peuvent être séparés les uns des autres pourvu que les durées des impulsions ne se recouvrent pas.

Lorsque $T_2$ est ouvert sous l'influence de $H_3$, les sorties de $R_2$ et $R_5$ sont électriquement réunies à l'entrée − d'un deuxième amplificateur $A_2$ dont l'entrée + est réunie à la masse par un troisième transistor interrupteur $T_3$, une résistance $R_6$ et un condensateur $C_2$. $T_3$ reçoit $H_3$ sur son électrode de commande et sert, avec $R_6$ et $C_2$, à compenser un saut d'horloge parasite dûe à l'échantillonnage. $A_2$ est monté en contre-réaction par une résistance $R_7$ entre sa sortie et l'entrée de $T_2$ et par un condensateur $C_3$ entre sa sortie et son entrée −. En prenant par exemple pour $C_3$ une valeur de 220 pF, pour $R_7$ une valeur de 8,25 kΩ, et pour $R_2$ et $R_5$ une valeur de 2 kΩ, on additionne les signaux transmis par $R_2$ et $R_5$, on multiplie le résultat de cette addition par un facteur sensiblement égal à 4 et on met en mémoire dans $C_3$ le résultat de ces opérations. Comme le signal transmis par $R_5$ est égal au signal transmis par $R_2$ mais retardé d'une durée $\tau$ et que l'opération effectuée par $A_2$ s'effectue pendant le temps $\tau$ qui suit la fin de chaque marche du signal $S_1$, on a (à un facteur multiplicatif et à un retard près) en sortie de $A_2$ un signal représentant la différence entre le signal $S_1$ (t) et le signal $S_1$ (t−T), T représentant la periode de l'horloge $H_1$.

Pour obtenir un interpolateur d'ordre 1 il faut, après avoir procédé à cette différence, procéder à une intégration du signal obtenu.

Pour cela, le signal en sortie de $A_2$ est appliqué par une résistance $R_8$ à l'entrée − d'un amplificateur $A_3$ monté en contre-réaction entre sa sortie et cette entrée par une résistance $R_9$ et un condensateur $C_4$. L'entrée + de $A_3$ est reliée à la masse par une résistance $R_{10}$. En prenant pour $R_8$ une valeur de 4,02 Ωk, pour $R_9$ une valeur de 40,2 kΩ, pour $C_3$ une valeur de 133 nF, et pour $R_{10}$ une valeur de 4 kΩ, cet étage se comporte comme un intégrateur et forme avec les étages précédents un interpolateur d'ordre 1 qui minimise considérablement les signaux hors-bande contenus dans le signal $S_1$.

Par rapport à un filtrage complémentaire du type comprenant des bobinages, un tel montage présente l'avantage d'être très facilement intégrable et délivre sur la sortie S de $A_3$ un signal de sortie dont les caractéristiques hors-bande sont particulièrement bonnes.

Selon l'invention, ou peut réaliser l'opération de soustraction obtenue dans l'exemple ci-dessus avec $A_1$ et $A_2$, dans le DTC lui-même. En effet un DTC opère par pondération sur un ensemble de n échantillons successifs du signal à filtrer s(t) à s(t−(n−1)T) en multipliant la valeur de ces échantillons par un ensemble de n poids $a_1$ à $a_n$ calculés selon les techniques connues de synthèse des filtres numériques.

Ainsi le signal $S_1(t)$ est donné par:

$$S_1(t) = a_1 \cdot s(t) + a_2 \cdot s(t-T) + \ldots +$$
$$a_{n-1} \cdot s(t-(n-2)T) + a_n \cdot s(t-(n-1)T).$$

Le signal $S_1(t-T)$ est donné par:

$$S_1(t-T) = a_1 \cdot s(t-T) + a_2 \cdot s(t-2T) + \ldots +$$
$$a_{n-1} \cdot s(t-(n-1)T) + a_n \cdot s(t-nT).$$

Le signal différence lui est donné par:

$$S_1(t) - S_1(t-T) = a_1 \cdot s(t) + (a_2 - a_1) \cdot s(t-T) +$$
$$(a_3 - a_2) \cdot s(t-2T) + \ldots + (a_n - a_{n-1}) \cdot$$
$$s(t-(n-1)T) - a_n \cdot s(t-nT).$$

On voit donc qu'on peut remplacer l'ensemble composé du DTC contenu dans le boitier 101 et des amplificateurs $A_1$ et $A_2$ avec leurs organes annexes par un autre DTC comprenant une cellule de plus et caractérisé par un ensemble de n+1 poids définis par: $a_1$, $a_2-a_1$, $a_3-a_2,\ldots$, $a_n-a_{n-1}$, $-a_n$. Ce DTC aura donc une cellule de pondération de plus que celle du DTC utilisé dans le montage de la figure 1. En quantité de matériel, cette seule cellule remplacera les deux amplificateurs $A_1$ et $A_2$ et leurs organes annexes. L'intégrateur formé par l'amplificateur $A_3$ et ses organes annexes, restera néanmoins nécessaire.

**Revendication**

Filtre à échantillonnage, du type comportant un dispositif à transfert de charges permettant de filtrer un signal entrant selon une courbe de réponse définie par un premier ensemble de coefficients de pondération $a_1$, $a_2,\ldots a_n$, caractérisé en ce que le dispositif à transfert de charges comprend n+1 cellules pondérées selon un deuxième ensemble des n+1 coefficients de pondération définis à partir des coefficients du premier ensemble par $a_1$, $a_2-a_1$, $a_3-a_2,\ldots a_n-a_{n-1}$, $-a_n$ et que le filtre comprend en outre un intégrateur (A3) pour recevoir le signal de sortie du dispositif de sortie du dispositif à transfert de charges et délivrer le signal de sortie du filtre.

**Patentanspruch**

Abtastfilter mit einer Ladungsverschiebevorrichtung, die es ermöglicht, ein Eingangssignal gemäß einer Ansprechkurve zu filtern, die durch eine erste Gruppe von Wichtungskoeffizienten $a_1$, $a_2\ldots a_n$ definiert ist, dadurch gekennzeichnet, daß die Ladungsverschiebeschaltung n+1 Stufen umfaßt, die gemäß einer zweiten Gruppe von n+1 Wichtungskoeffizienten gewichtet sind, die ausgehend von den Koeffizienten der ersten Gruppe definiert sind durch $a_1$, $a_2-a_1$, $a_3-a_2$,...$a_n-a_{n-1}$, $-a_n$, und daß das Filter ferner einen Integrator (A3) zum Entgegennehmen des Ausgangssignals der Ausgabevorrichtung der Ladungsverschiebeschaltung und zum Abgeben des Ausgangssignals des Filters umfaßt.

**Claim**

Sampling filter of the type comprising a charge transfer device permitting filtering of an input signal in accordance with a response curve defined by a first set of weighting coefficients $a_1$, $a_2$...$a_n$, characterized in that the charge transfer device comprises $n+1$ stages weighted in accordance with a second set of $n+1$ weighting coefficients defined, on the basis of the coefficients of the first group, by $a_1$, $a_2-a_1$, $a_3-a_2$,...$a_n-a_{n-1}$, $-a_n$, and in that the filter further comprises an integrator (A3) receiving the output signal of the output device of the charge transfer device and supplying the output signal of the filter.

Fig.1

Fig. 2